# FASCICULE DE BREVET EUROPEEN

(11) **EP 3 701 572 B1**
(45) Date de publication et mention de la délivrance du brevet: **13.07.2022**
(21) Numéro de dépôt: 18772821.7
(22) Date de dépôt: 26.09.2018
(51) Int. Cl.: H01L 41/113, G01N 29/04, G01N 29/24

(54) **STRUCTURE ALVEOLAIRE COMPRENANT UN DISPOSITIF DE CONTROLE D'INTEGRITE ET PROCEDE DE CONTRÔLE D'UNE TELLE STRUCTURE**
WABENSTRUKTUR MIT EINER INTEGRITÄTSÜBERWACHUNGSVORRICHTUNG UND VERFAHREN ZUR ÜBERWACHUNG EINER SOLCHEN STRUKTUR
HONEYCOMB STRUCTURE COMPRISING AN INTEGRITY MONITORING DEVICE AND METHOD FOR MONITORING SUCH A STRUCTURE

(30) Priorité: 28.09.2017 FR 1758995
(43) Date de publication de la demande: 02.09.2020
(73) Titulaire: Commissariat à l'Energie Atomique et aux Energies Alternatives, 75015 Paris (FR); Safran, 75015 Paris (FR)
(72) Inventeur: CHAPUIS, Bastien, 78220 Viroflay (FR); BOLZMACHER, Christian, 92120 Montrouge (FR); LAFFONT, Guillaume, 92190 Meudon (FR)
(74) Mandataire: Marks & Clerk France
(86) Numéro de dépôt international: PCT/EP2018/076061
(87) Numéro de publication internationale: WO 2019/063588

(56) Documents cités:
- WO-A1-2015/068082
- FR-A1- 2 917 166
- KR-A- 20090 005 999
- H. ABRAMOVITCH ET AL: "Sensing and actuation of smart chiral honeycombs", SPIE DEFENSE AND SECURITY SYMPOSIUM; 16-20 MARCH 2008; ORLANDO, FLORIDA, UNITED STATES, vol. 6935, 27 mars 2008 (2008-03-27), page 693506, XP055484114, US ISSN: 0277-786X, DOI: 10.1117/12.775588 ISBN: 978-1-5106-1723-0

## Description

### DOMAINE TECHNIQUE DE L'INVENTION

L'invention se situe dans le domaine du contrôle d'intégrité de structures, également nommé « contrôle santé », en anglais SHM pour Structural Health Monitoring. L'invention vise particulièrement les structures en nid d'abeille ou plus largement les structures alvéolaires.

L'invention concerne plus précisément le contrôle par des ondes élastiques, et avantageusement des ondes élastiques guidées, c'est-à-dire des ondes élastiques dont la propagation est guidée par la structure à contrôler. Ces ondes peuvent se propager sur une distance relativement longue et peuvent être émises et reçues à l'aide d'un ou de plusieurs transducteurs placés à un seul ou à plusieurs endroits.

### ETAT DE LA TECHNIQUE

Le Structural Health Monitoring (SHM) consiste à intégrer des capteurs dans une structure afin de suivre son état de santé (détection de défauts). Un des avantages par rapport aux méthodes de contrôle non destructif « classiques » est que, les capteurs étant embarqués, il n'y a plus besoin de démonter des composants pour accéder à la structure à contrôler. On évite ainsi des fragilisations éventuelles en cas de démontage/remontage et on économise du temps lors des opérations de maintenance qui sont par ailleurs très contraintes. Cela permet de réduire le temps d'immobilisation de la structure à contrôler.

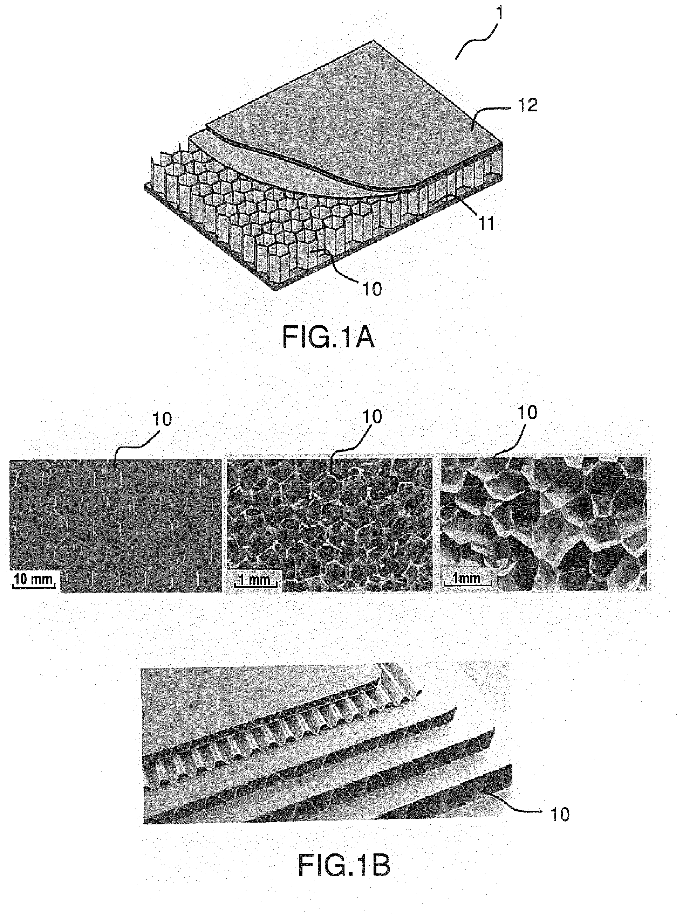

Une des applications du SHM est le contrôle de structures 1 sandwich en nid d'abeille comprenant une âme en nid d'abeille 10 prise en sandwich entre une première surface (ou peau) 11 et une seconde surface (ou peau) 12, comme représenté en figure 1A.

Dans la présente description, une structure « en nid d'abeille » sera comprise plus largement comme une structure comprenant plusieurs alvéoles, chaque alvéole étant une cavité délimitée par une paroi. La paroi présente une section généralement hexagonale ou plus largement polygonale. Elle peut donc comprendre un certain nombre de faces (six faces dans le cas d'une section hexagonale, plusieurs faces plus largement dans les cas des sections polygonales).

Alternativement la paroi peut présenter une section courbe (par exemple de section elliptique), ou encore d'autres formes plus aléatoires comme illustré en figure 1B : par exemple, les alvéoles 10 peuvent présenter des sections moins régulières, elles peuvent être fermées ou ouvertes, ou présenter des sections de type sinusoïdal.

L'âme alvéolaire procure à la structure une résistance en flexion plus importante, une plus grande capacité de déformation (selon le type d'âme utilisé), ainsi qu'un taux de vide avoisinant les 95 % permettant une légèreté de la structure.

La ou les peaux sont souvent réalisées en un matériau stratifié, par superposition de plusieurs couches de feuilles.

On parle de matériau stratifié composite lorsque les feuilles comportent au moins deux matériaux différents. En général il s'agit de fibres de carbones ou de verre noyées dans une matrice en résine en polymères époxyde (dite « résine époxyde »).

Dans la suite du présent document, une telle structure pourra être désignée par « structure sandwich en nid d'abeille » ou « structure sandwich alvéolaire ».

Elle peut ne pas comprendre de peaux. C'est pourquoi, on parlera plus généralement dans la présente description de « structure » ou « structure alvéolaire », par souci de simplicité.

De telles structures sont par exemple régulièrement employées notamment dans le milieu aéronautique pour leur excellent ratio masse/performances mécaniques. A titre d'exemple, dans un avion, la pièce appelée IFS (inner fixed structure) qui est une partie de la nacelle (capot qui entoure le réacteur d'un avion) peut comprendre une structure en nid d'abeille.

Toutefois, sous l'effet d'impacts, de vieillissement par exemple thermo-mécanique, ou sous l'influence de l'environnement dans lequel la structure évolue, des dommages tels que des délaminages des peaux composites ou des décollements entre une peau composite et le nid d'abeille peuvent apparaitre ou des dommages sur des alvéoles. Il est donc essentiel dans le domaine de l'aéronautique ou dans d'autres domaines tels que le nautique, le spatial, le transport terrestre (ferroviaire, automobile), l'énergie éolienne de suivre l'évolution de l'état de santé de telles structures et ce, afin de prévenir de potentielles ruptures.

Il est connu d'intégrer des transducteurs piézoélectriques à la surface des peaux composites.

Par souci de simplification, le terme « transducteur » signifiera « transducteur piézoélectrique » dans la suite de la présente description.

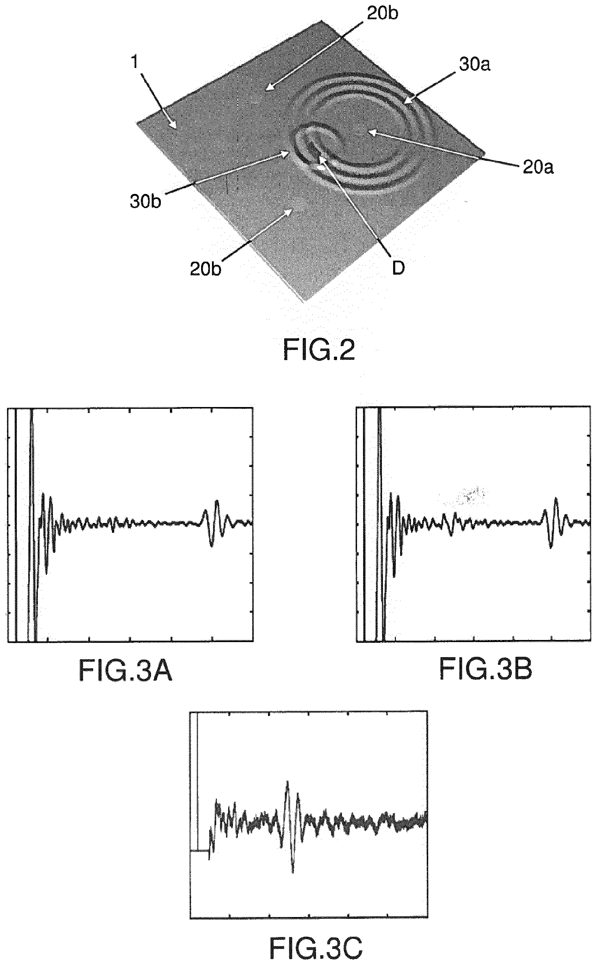

Comme illustré en figure 2, les transducteurs piézoélectriques sont utilisés comme émetteurs et/ou récepteurs d'ondes élastiques guidées. Dans l'exemple représenté, un premier transducteur 20a est en mode émission (on pourra parler par la suite de transducteur émetteur), un deuxième et un troisième transducteurs 20b sont en mode réception (on pourra parler par la suite de transducteur récepteur). L'onde élastique émise 30a se propage en étant guidée par la structure 1. Elle rencontre un défaut D qui modifie ses caractéristiques et la diffracte. Une onde élastique diffractée 30b issue de l'onde élastique émise 30a et dont les caractéristiques sont modifiées est reçue par le deuxième et/ou le troisième transducteur 30b. Mais elle pourrait aussi être reçue en retour par le premier transducteur 20a, et celui-ci devrait être dans ce cas basculé en mode réception afin de recevoir l'onde élastique de retour.

La diffraction des ondes élastiques sur un défaut fournit ainsi une signature spécifique qu'il est possible d'analyser afin de détecter la présence de ce défaut, de le localiser et de le dimensionner.

Par exemple, la demande de brevet US2016/0313286 divulgue un procédé et un dispositif de détection de dommages dans des composants de moteurs à turbine. Les composants comprennent une âme en nid d'abeille prise en sandwich entre deux peaux composites. L'une des peaux composites peut être couplée à une structure acoustique pour réduire le bruit et/ou à une structure de protection thermique pour protéger la peau des températures élevées. Plusieurs systèmes de fixations permettent de coupler la peau composite à la structure acoustique et/ou thermique, par exemple sous forme de poteau traversant la structure acoustique et/ou thermique et relié à la peau, le poteau coopérant avec un capuchon permettant de maintenir la structure contre la peau. Un dispositif de transmission peut être couplé à une première fixation, et un dispositif de réception peut être couplé à une deuxième fixation. Le dispositif de transmission peut transmettre un signal, par exemple généré par une onde ultrasonore, à travers la première fixation, le long de la peau composite, puis à travers la deuxième fixation et jusqu'au dispositif de réception. Le dispositif de réception peut ainsi recevoir le signal. Le signal peut être utilisé et analysé pour identifier les dommages dans le composite. Ainsi, des dommages peuvent être détectés dans le composite sans enlever la structure acoustique ou la structure thermique.

Les dispositifs de transmission/réception sont des transducteurs piézoélectriques.

L'inconvénient majeur de ce positionnement des transducteurs piézoélectriques est qu'ils sont exposés aux agressions extérieures (risques d'impacts, agressions dues à l'environnement ou à la présence de produits chimiques) ce qui limite leur durée de vie. Ainsi cela peut conduire par exemple à la rupture ou au décollement du transducteur.

Par ailleurs, la disposition des transducteurs piézoélectriques est restreinte aux positions des attaches (qui sont en un nombre réduit), ce qui limite le nombre de capteurs qui peuvent être embarqués et donc la quantité d'informations que l'on peut récupérer sur la structure et en conséquence la qualité du diagnostic. L'article de H. Abramovitch et al., "Sensing and actuation of smart chiral honeycombs"; Proc. SPIE 6935, Health Monitoring of Structural and Biological Systems 2008, 693506, p. 1-7, (2008), doi : 10.1117 / 12.775588 décrit une structure alvéolaire dont les alvéoles sont respectivement délimitées par une pluralité de parois.

### EXPOSE DE L'INVENTION

L'invention vise à surmonter les inconvénients précités de l'art antérieur.

Plus particulièrement elle vise à disposer d'un dispositif de contrôle par onde élastique qui permette de réaliser le contrôle d'une structure alvéolaire, ce, sans avoir à démonter la pièce dans laquelle ladite structure est intégrée, en limitant l'intrusivité et surtout le risque de fragilisation de ladite structure ou du dispositif de contrôle, et présentant une meilleure résistance des transducteurs aux agressions extérieures.

En outre l'invention vise à permettre à l'onde élastique de parcourir une distance maximale pour une puissance donnée de l'onde élastique émise.

Un objet de l'invention permettant d'atteindre ce but est une structure alvéolaire comprenant plusieurs alvéoles, chaque alvéole étant délimitée par une paroi, ladite structure alvéolaire comportant un dispositif de contrôle d'intégrité comprenant :
- au moins un transducteur piézoélectrique apte à émettre une onde élastique de manière à ce que ladite onde émise se propage sur une distance donnée dans la structure, et positionné sur la paroi d'une alvéole de ladite structure de manière à présenter au moins un point de contact avec ladite alvéole ;
- au moins un transducteur piézoélectrique apte à recevoir, depuis l'onde élastique émise, une onde élastique s'étant propagée sur une distance donnée dans la structure, et positionné sur la paroi d'une alvéole de ladite structure de manière à présenter au moins un point de contact avec ladite alvéole.

Selon l'invention, au moins une alvéole comprend plusieurs transducteurs piézoélectriques, formant ainsi un bloc de transducteurs.

La structure alvéolaire selon l'invention permet de disposer d'un dispositif de contrôle offrant de grands avantages aussi bien en termes de puissance du signal émis qu'en termes d'intrusivité réduite : meilleure résistance des transducteurs aux agressions extérieures et moins de risque de créer des fragilités de la peau composite par rapport à des dispositifs disposés sur une peau d'une structure alvéolaire sandwich. Le transducteur étant intégré dans la partie alvéolaire, il est protégé des agressions externes. Il peut être maintenu à demeure dans la structure. L'invention permet d'éviter d'avoir à démonter la pièce dans laquelle la structure est intégrée. Elle permet également d'éviter d'avoir à démonter la structure elle-même.

Les transducteurs utilisés dans le contrôle des structures exploitent des hautes fréquences acoustiques et des fréquences d'ultrasons (d'une dizaine kHz à quelques centaines de kHz). Les transducteurs sont de taille relativement petite et par conséquent légers, ce qui leur permet d'être positionnés sur une paroi d'une alvéole sans risquer de déformer celle-ci et donc la structure.

En outre, il n'est pas nécessaire de rajouter un élément à l'intérieur de l'alvéole pour maintenir un transducteur, puisque la paroi de l'alvéole suffit. L'invention permet donc de disposer d'un dispositif de contrôle léger, présentant un risque très minime de fragiliser la structure.

Il est précisé que la largeur d'un transducteur est définie comme étant sa plus grande dimension dans la direction de la tangente de l'alvéole au niveau du point de contact entre le transducteur et la paroi de l'alvéole et que l'épaisseur d'un transducteur est définie comme étant sa plus grande dimension dans la direction perpendiculaire à ladite tangente.

En utilisant des transducteurs moins larges, elle permet d'augmenter l'épaisseur de ceux-ci afin d'augmenter la puissance des ondes émises.

Cela peut permettre en outre de limiter le nombre de transducteurs à disposer sur la surface de la structure, et de limiter la quantité de câblage.

Alternativement, comme l'intrusivité de la solution est limitée, il est possible de disposer une densité de transducteurs plus importante sur une surface donnée, et ce, afin de multiplier la qualité et la fiabilité d'information qu'un transducteur seul est possible de récupérer.

Le fait d'avoir un bloc de transducteurs dans au moins une alvéole permet de couvrir la structure le plus largement possible et d'augmenter la puissance totale émise si les transducteurs sont émetteurs. En particulier, si les transducteurs sont répartis régulièrement dans l'alvéole et s'ils fonctionnent en émission, cela permet d'émettre des ondes élastiques le plus axisymétriquement possible autour du bloc. Si les transducteurs sont répartis régulièrement dans l'alvéole et s'ils fonctionnent en réception, cela permet de recevoir plus sûrement des ondes élastiques depuis les ondes élastiques émises.

D'une manière générale, le fait d'avoir un bloc de transducteurs dans au moins une alvéole permet multiplier les émetteur et les récepteurs d'ultrasons embarqués dans la structure, ce qui multiplie la quantité d'informations qui peut être obtenue sur la structure, et ce qui renforce donc la qualité de l'analyse. Cela permet notamment d'obtenir un diagnostic plus fiable sur l'état de santé de la structure.

En outre, lorsque l'on a un bloc de plusieurs transducteurs dans une alvéole, il est possible de mettre en œuvre la technique dite de « Embedded Ultrasonic Structural Radar » qui consiste à scanner circulairement la structure dans le plan, sur le principe d'un radar tournant, pour produire une image de la structure.

Le câblage nécessaire aux transducteurs peut cheminer entre les alvéoles dans des évidements prévus à cet effet ou déjà existants dans celles-ci, par exemple entre chaque alvéole et une des peaux composites, puis le long de ladite peau. Ainsi, le cheminement et la protection du câblage peut être facilité du fait même de la structure alvéolaire.

L'électronique des transducteurs (ou au moins de quelques-uns) peut avantageusement être intégrée dans une alvéole afin de minimiser le câblage.

Le dispositif de contrôle s'intègre aisément à une structure alvéolaire, dont les alvéoles sont vides, et peut être aisément intégré dans un procédé de fabrication de ladite structure alvéolaire.

En outre, le dispositif de contrôle est très aisément modulable, adaptable en fonction de la structure. En effet, il est possible d'avoir plusieurs schémas d'implantation des transducteurs dans une alvéole et/ou dans plusieurs alvéoles. Il est possible d'utiliser différents types et/ou différentes dimensions de transducteurs acoustiques piézoélectriques. Il est également possible de les associer avec d'autres types de capteurs.

Selon un mode de réalisation, un transducteur piézoélectrique apte à émettre une onde élastique et un transducteur piézoélectrique apte à recevoir une onde élastique peut être un seul transducteur piézoélectrique apte à émettre et à recevoir une onde élastique. Un transducteur peut fonctionner en mode pulse-echo : l'onde élastique émise, lorsqu'elle rencontre un défaut, renvoie vers le transducteur une onde élastique diffractée dont le signal porte l'empreinte dudit défaut. Dans ce cas, il est nécessaire de disposer de moyens de commutation permettant de basculer ledit transducteur d'un mode émission à un mode réception ; puis de le basculer à nouveau en mode émission, et de répéter ces opérations. Ce basculement soit être suffisamment rapide pour que le transducteur ait le temps de recevoir l'onde élastique diffractée par le défaut, typiquement inférieur à la microseconde.

Selon un mode de réalisation alternatif, la structure alvéolaire comprend au moins un premier transducteur piézoélectrique émetteur (apte à émettre une onde élastique) positionné sur une première alvéole et au moins un deuxième transducteur piézoélectrique récepteur (apte à recevoir une onde élastique) positionné sur une seconde alvéole. Les deux transducteurs sont disposés au sein de deux alvéoles distinctes et suffisamment éloignées pour pouvoir détecter un défaut dans la structure le plus efficacement et sûrement possible.

Il est encore plus avantageux de disposer d'un réseau de transducteurs astucieusement répartis dans la structure, afin de détecter encore plus sûrement tout défaut dans la structure.

Selon un mode de réalisation particulier, la structure alvéolaire comprend au moins deux transducteurs en opposition de phase.

On entend par « opposition de phase » le fait que deux transducteurs émettent des ondes élastiques de même fréquence mais déphasées l'une par rapport à l'autre d'une demie période. Pour être en opposition de phase, un premier et un deuxième transducteurs peuvent être par exemple alimentés par des courants électriques en opposition de phase. Alternativement et préférentiellement, les électrodes du premier transducteur peuvent être inversées par rapport à celles du deuxième transducteur.

Selon un mode de réalisation préféré, l'onde élastique est une onde ultrasonore.

Selon un mode de réalisation préféré, les parois délimitant les alvéoles de la structure alvéolaire présentent chacune une section polygonale, de préférence hexagonale. Ainsi une paroi présente plusieurs faces latérales (nommées « faces » par la suite), par exemple six faces dans le cas d'un hexagone.

Selon un mode de réalisation particulier, un bloc comprend des transducteurs répartis sur une ou plusieurs faces d'une alvéole. Cette configuration est possible dans le cas où les parois des alvéoles présentent des sections polygonales.

Selon un mode de réalisation particulier, un bloc comprend des transducteurs répartis sur des faces adjacentes de l'alvéole. Cette configuration permet d'émettre des ondes élastiques dans un champ privilégié (ou selon un angle solide donné).

Selon un mode de réalisation, le bloc comprend des transducteurs régulièrement répartis sur les faces de l'alvéole. Cette configuration permet d'émettre des ondes élastiques le plus axisymétriquement possible autour du bloc.

Selon un mode de réalisation particulier, le bloc comprend des transducteurs répartis sur chacune des faces de l'alvéole. Cette configuration permet de renforcer l'aspect axisymétrique des ondes élastiques émises.

Selon un mode de réalisation, au moins une première alvéole comporte un bloc émetteur comprenant des transducteurs émetteurs et au moins une seconde alvéole comporte au moins un transducteur récepteur.

Selon un mode de réalisation, au moins au moins une première alvéole comporte un bloc émetteur comprenant des transducteurs émetteurs et au moins une seconde alvéole comporte un bloc récepteur comprenant des transducteurs récepteurs.

Selon un mode de réalisation, le dispositif de contrôle d'intégrité comprend en outre des moyens de traitement du signal de l'onde élastique reçue, aptes à déterminer le niveau d'intégrité de ladite structure. Dans ce cas, les transducteurs doivent être reliés aux moyens de traitement. Cela permet de créer un système complet allant de la création de signaux générés par les ondes élastiques jusqu'au traitement desdits signaux, de manière à pouvoir détecter un défaut ou de conclure à une absence de défaut.

Selon un mode de réalisation, le dispositif de contrôle d'intégrité comprend en outre des moyens de commande du au moins un transducteur.

Selon un mode de réalisation particulier, les moyens de commande comprennent des moyens de commutation aptes à basculer au moins un transducteur du mode émission à un mode réception et inversement.

Selon un mode de réalisation, les moyens de traitement comprennent des moyens de soustraction du signal de l'onde élastique reçue et d'un signal de référence correspondant à une structure alvéolaire saine. Le signal de référence peut être obtenu par modélisation ou expérimentalement.

Selon un mode de réalisation, le dispositif de contrôle d'intégrité comprend en outre un capteur de température, les moyens de traitement étant configurés pour utiliser une mesure de température acquise par ledit capteur. Ceci permet de normaliser les signaux des ondes élastiques (en amplitude ou en déphasage).

Un autre objet de l'invention est un procédé de contrôle d'intégrité d'une structure composite alvéolaire comprenant les étapes suivantes :
- l'émission d'une onde élastique au moyen d'un transducteur piézoélectrique de manière à ce que ladite onde émise se propage sur une distance donnée dans la structure alvéolaire ;
- la réception par un transducteur piézoélectrique, depuis l'onde élastique émise, d'une onde élastique s'étant propagée sur une distance donnée dans la structure alvéolaire ;
- le traitement du signal de l'onde élastique reçue de manière à déterminer le niveau d'intégrité de ladite structure alvéolaire ; chaque transducteur piézoélectrique étant positionné sur la paroi d'une alvéole de la structure alvéolaire de manière à présenter au moins un point de contact avec ladite alvéole.

Selon l'invention, au moins une alvéole comprend plusieurs transducteurs piézoélectriques, formant ainsi un bloc de transducteurs.

Selon un mode de réalisation, le procédé de contrôle comprend une étape de commutation d'un transducteur piézoélectrique du mode émission au mode réception.

Selon un mode de réalisation, le procédé de contrôle comprend une étape de commutation d'un transducteur piézoélectrique du mode réception au mode émission.

Selon un mode de réalisation, au moins un premier transducteur piézoélectrique fonctionne en mode émission, et au moins deuxième transducteur piézoélectrique fonctionne en mode réception.

Selon un mode de réalisation, l'étape de traitement comprend une étape de soustraction du signal de l'onde élastique reçue et d'un signal de référence.

Selon un mode de réalisation, le procédé de contrôle comprend en outre une étape de mesure de température au niveau de la structure alvéolaire, l'étape de traitement utilisant une mesure de température acquise par ledit capteur.

Un autre objet de l'invention est une pièce d'avion comportant une structure alvéolaire selon l'invention.

### DESCRIPTION DES FIGURES

D'autres caractéristiques et avantages de l'invention apparaîtront à l'aide de la description qui suit donnée à titre illustratif et non limitatif, faite en regard des figures annexées parmi lesquelles
- les figures 1A et 1B illustrent une structure composite alvéolaire connue, avec différentes formes d'alvéoles ;
- la figure 2 illustre le principe du contrôle santé d'une structure par ondes élastiques guidées émises et détectées par un réseau de transducteurs piézoélectriques ;
- les figures 3A à 3C illustrent un mode d'analyse par soustraction des ondes élastiques pour détecter un défaut ;
- la figure 4 illustre un premier mode de réalisation de l'invention ;
- la figure 5 illustre un second mode de réalisation de l'invention ;
- les figures 6A à 6C illustrent trois modes particuliers de réalisation de l'invention dans lesquels les transducteurs sont disposés selon plusieurs configurations au sein d'une alvéole ;
- la figure 7 illustre un mode particulier de réalisation de l'invention dans lesquels les transducteurs sont en opposition de phase ;
- les figures 8A à 8C illustrent trois types de déformations d'éléments piézoélectriques pouvant être mis en oeuvre dans l'invention;
- les figures 9A à 9D montrent comment une onde émise par un transducteur émetteur se propage lorsqu'elle rencontre un défaut ;
- la figure 10 illustre un exemple de dispositif de contrôle, incluant les moyens de traitement et de commande.

### EXPOSÉ DÉTAILLÉ DE MODES DE RÉALISATION PARTICULIERS

Les figures 1A et 2 ont été décrites au début de la présente description et ne seront pas reprises ici.

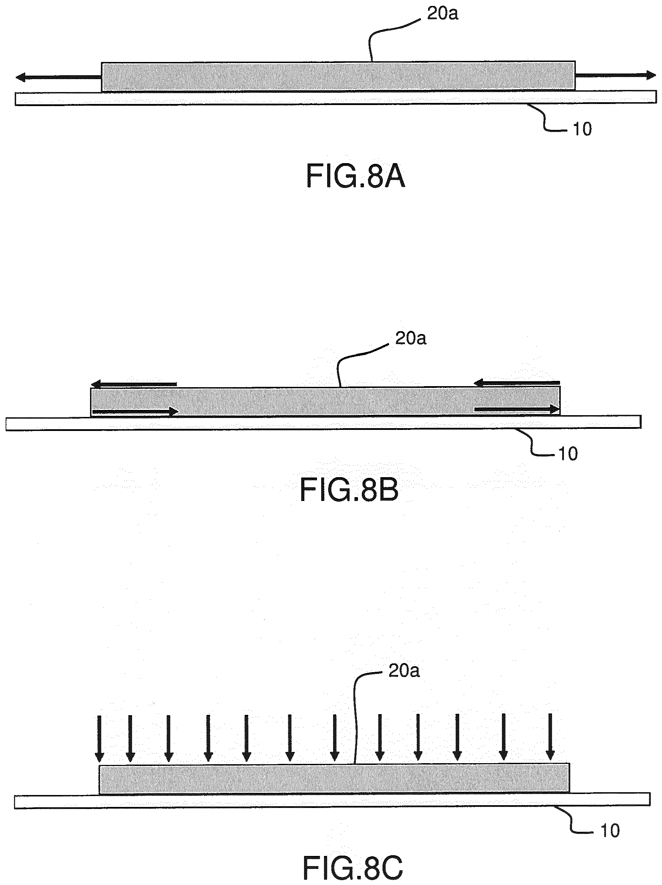

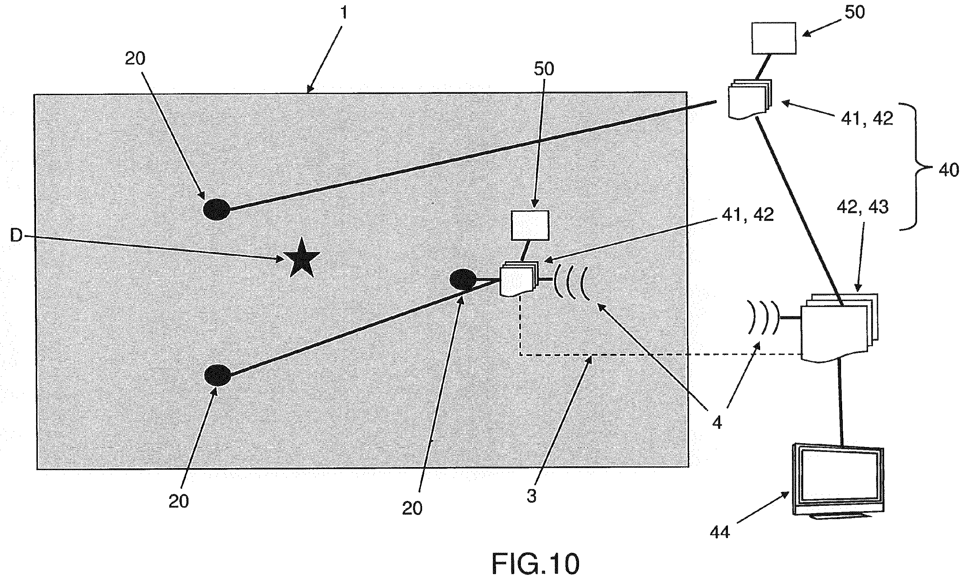

Dans les figures qui suivent (sauf les figures 8A à 8C et 10), les alvéoles 10 présentent une section hexagonale : on parle de nid d'abeille. Alternativement, elles peuvent présenter des sections moins régulières, elles peuvent être fermées ou ouvertes, des alvéoles peuvent présenter des sections de type sinusoïdal, comme illustré en figure 1B.

Les transducteurs piézoélectriques sont utilisés comme émetteurs et/ou récepteurs d'ondes élastiques guidées. La diffraction des ondes élastiques sur un ou des défauts fournit une signature spécifique, et c'est cette signature qui est analysée par les moyens de traitement pour détecter, localiser et dimensionner un ou des défauts dans la structure.

Les moyens de traitement peuvent comprendre des moyens de calcul simples ou des algorithmes ou modèles plus complexes aptes à détecter, localiser et dimensionner un ou des défauts de la structure.

Comme illustré en figures 3A à 3C, les moyens de calcul peuvent consister en une soustraction du signal de l'onde élastique reçue (fig 3B) par rapport à un signal d'onde élastique de référence (fig 3A) afin d'obtenir directement le signal diffracté par le défaut (fig 3C). Ce mode de calcul est adapté lorsqu'il n'y a pas un grand réseau de transducteurs. D'autres stratégies de comparaison entre le signal reçu et un signal de référence que la simple soustraction peuvent être mises en place afin d'obtenir le signal diffracté par le défaut de manière plus robuste, et peuvent prendre en compte les variations environnementales (notamment les variations de la température).

Alternativement, les moyens de calcul peuvent se baser sur la fusion d'informations provenant de différents capteurs, par exemple en utilisant un algorithme d'imagerie tel que la tomographie, comme décrit dans le brevet FR3014200. Ce mode de calcul est adapté lorsqu'il y a un nombre important de transducteurs. Et il permet d'éviter de faire le calcul par soustraction, qui peut être source de fausses alarmes, notamment en cas de variations environnementales importantes entre les deux mesures.

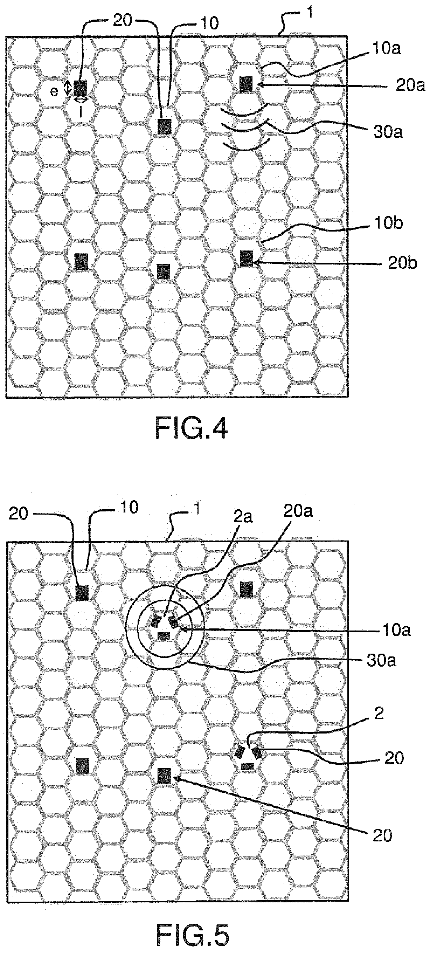

La figure 4 illustre un premier mode de réalisation de l'invention, dans lequel plusieurs alvéoles 10 comprennent un seul transducteur 20. Dans ce cas, le transducteur 20 peut présenter une épaisseur « e » importante, dans la limite des dimensions intérieures de l'alvéole 10. De préférence, on répartit les alvéoles avec transducteur d'une manière astucieuse au sein de la structure 1 de manière à couvrir ladite structure le plus largement possible. Au moins un premier transducteur 20a fonctionne en émission (on peut parler de transducteur émetteur) et est positionné sur la paroi d'une première alvéole 10a et au moins un second transducteur 20b fonctionne en réception (on peut parler de transducteur émetteur) et est positionné sur la paroi d'une seconde alvéole 10b.

Afin de favoriser une couverture complète de la structure à contrôler avec un nombre minimal de transducteurs, il est parfois préférable de rendre le champ d'ondes élastiques émis le plus axisymétrique possible.

Alternativement ou en complément, on peut aussi vouloir renforcer l'émission des ondes élastiques uniquement selon un angle solide donné.

En outre, dans de nombreux cas, il est judicieux d'intégrer plusieurs transducteurs au sein d'une même alvéole.

Ainsi, la figure 5 illustre un second mode de réalisation de l'invention dans lequel certaines alvéoles 10 comprennent un seul transducteur 20 fonctionnant en émission ou en réception, et d'autres alvéoles 10 comprennent un bloc 2 de trois transducteurs 20 fonctionnant en émission ou en réception, et par exemple régulièrement répartis sur la paroi de l'alvéole (ici sur trois des six faces d'une alvéole hexagonale). On répartit les transducteurs 20a fonctionnant en émission et les transducteurs 20b fonctionnant en réception d'une manière astucieuse de manière à couvrir la structure 1 le plus largement possible. Dans l'exemple représenté, au moins une alvéole 10a comprend un bloc 2a de trois transducteurs émetteurs 20a, et au moins trois alvéoles 10 comprennent chacune un seul transducteur récepteur 20b.

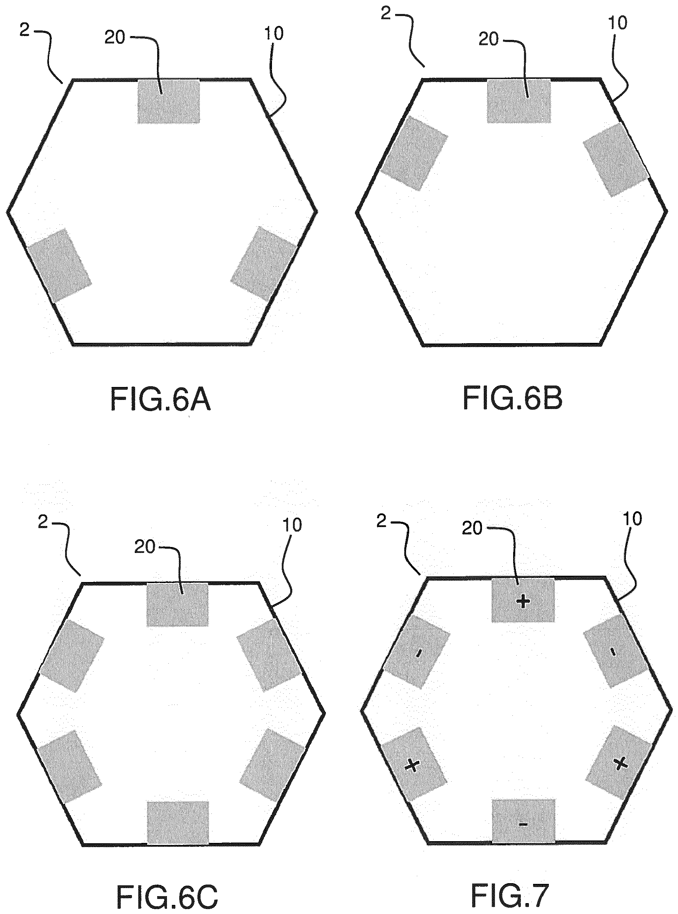

Les figures 6A à 6C illustrent plusieurs modes particuliers de réalisation qui correspondent à plusieurs arrangements de transducteurs 20 dans une alvéole 10, en d'autres termes plusieurs arrangements de blocs 2.

La figure 6A illustre un bloc 2 comprenant trois transducteurs 20 répartis régulièrement sur trois des six faces d'une alvéole 10 hexagonale. Si les trois transducteurs 20 fonctionnent en émission, cela permet d'avoir un champ d'ondes élastiques émis axisymétriquement. Si les trois transducteurs 20 fonctionnent en réception, cela permet de recevoir plus sûrement des ondes élastiques depuis les ondes élastiques émises.

La figure 6B illustre un bloc comprenant trois transducteurs répartis sur trois faces adjacentes d'une alvéole hexagonale. Si les trois transducteurs 20 fonctionnent en émission, cela permet d'avoir un champ d'ondes élastiques émis selon un angle solide donné.

La figure 6C illustre un bloc comprenant six transducteurs répartis sur les six faces d'une alvéole hexagonale. Si les trois transducteurs 20 fonctionnent en émission, cela permet d'avoir un champ d'ondes élastiques émis encore plus axisymétriquement tout en limitant le champ proche au transducteur (zone dans laquelle l'interprétation des signaux est plus délicate) par rapport à la configuration de la figure 6A. Si les six transducteurs 20 fonctionnent en réception, cela permet de recevoir encore plus sûrement des ondes élastiques depuis les ondes élastiques émises.

Dans les figures 5 à 6C, les transducteurs 20 sont connectés afin d'émettre en phase. Cela permet d'augmenter la puissance totale émise.

La figure 7 illustre un mode de réalisation particulier dans lequel certains transducteurs 20 sont en opposition de phase. Cela permet de renforcer certains modes de propagation d'ondes ou certaines directions de propagation privilégiées.

En multipliant plusieurs combinaisons possibles, il est possible de générer différentes combinaisons d'ondes élastiques qui vont interroger la structure, ce qui augmente les informations quant à son état de santé.

Les éléments piézoélectriques des transducteurs peuvent être par exemple sous forme de cristaux, de céramiques ou de polymères céramiques.

Il peut s'agir d'éléments PZT (Titano-Zirconate de Plomb).

Il peut également s'agir de polymères PVDF qui présentent un intérêt lorsqu'il faut coller le transducteur sur une surface de géométrie complexe.

Différents types d'éléments piézoélectriques peuvent être combinés.

Il est également possible de combiner des transducteurs disposés sur la paroi d'une alvéole avec des transducteurs positionnés sur une ou plusieurs peau(x) d'une structure alvéolaire sandwich.

Les figures 8A à 8C illustrent trois modes de déformations générées par un transducteur émetteur 20a positionné sur une paroi d'une alvéole 10. La figure 8A illustre le mode longitudinal, la figure 8B le mode en cisaillement et la figure 8C le mode normal. Ces différents modes de déformations permettent de privilégier, en fonction de la configuration d'intégration des capteurs et de la fréquence, l'émission d'un mode guidé ou d'un autre dans la structure.

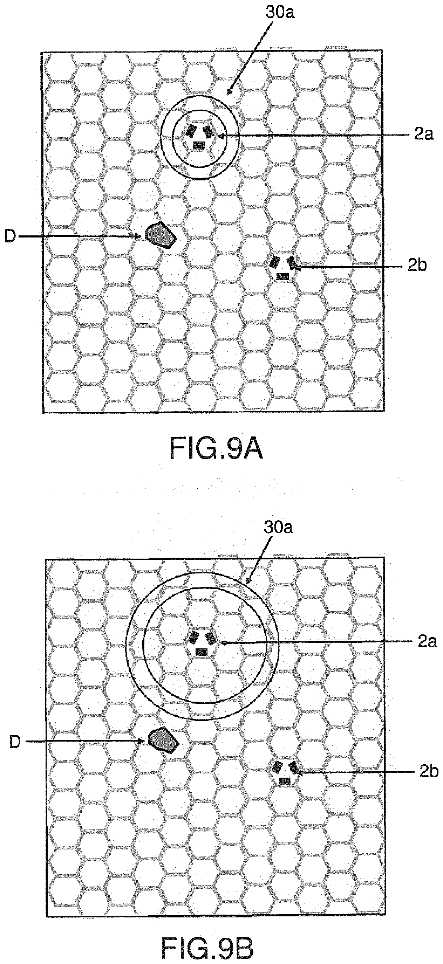

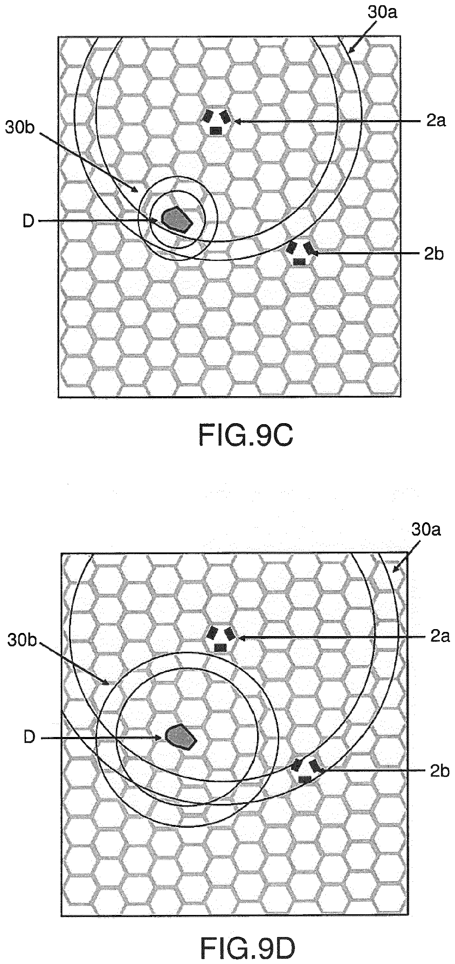

Les figures 9A à 9D montrent comment une onde élastique émise par un transducteur se propage lorsqu'elle rencontre un défaut D. Dans le mode représenté, le dispositif de contrôle d'intégrité comprend un bloc émetteur 2a comprenant trois transducteurs 20a en mode émission et un bloc récepteur 2b comprenant trois transducteurs 20b en mode réception. Les trois transducteurs du bloc 2a produisent un champ d'ondes élastiques 30a émises dans toutes les directions autour du bloc 2a. Les figures 9A et 9B illustrent la progression de l'émission des ondes élastiques. En figure 9C, l'onde élastique émise 30a atteint le défaut D et crée une diffraction de l'onde. Une onde élastique diffractée 30b est ainsi générée. Elle est reçue par le bloc récepteur 2b. Alternativement, le bloc récepteur 2b pourrait être remplacé par un seul transducteur 20b en mode réception. Dans un autre mode alternatif, il pourrait ne pas y avoir de bloc récepteur 2b ou de transducteur récepteur 20b et le bloc 2a pourrait aussi fonctionner en mode récepteur. Dans ce cas, il faut prévoir un système de commutation du mode émission au mode réception et inversement.

Les transducteurs 20 sont positionnés sur la paroi de certaines alvéoles de la structure. Ils peuvent être par exemple collés ou soudés.

La figure 10 illustre un exemple de dispositif de contrôle qui peut être combiné avec l'un quelconque des modes de l'invention et qui inclut des moyens de traitement 40 et des moyens de commande 50 associés aux transducteurs 20.

La figure 10 illustre des transducteurs 20 mais cela peut être des blocs 2 de transducteurs.

Les moyens de traitement 40 comprennent :
- des moyens d'acquisition 41 des signaux ;
- des moyens de calcul 42.

Les moyens d'acquisition 41 des signaux comprennent en général des moyens de numérisation. Ils peuvent également comprendre des moyens de conditionnement et/ou de filtrage des signaux.

Les moyens de calcul 42 peuvent contenir des algorithmes de détection, de localisation et de dimensionnement des défauts de la structure 1.

Les moyens de traitement 40 peuvent également comprendre des moyens de stockage des signaux 43 et des moyens d'affichage 44.

Dans le cas d'une communication filaire, des fils ou des câbles de connexion 3 sont prévus pour connecter les transducteurs 20 aux moyens de traitement 40 des transducteurs.

En général, les moyens d'acquisition 41 sont disposés dans une unité à proximité du transducteur 20. Ils comprennent des moyens de numérisation des signaux de sorte que la communication filaire transporte un signal numérique vers les moyens de calcul 42.

Alternativement, les moyens d'acquisition 41 peuvent être déportés dans une unité plus éloignée du transducteur. Dans ce cas, la communication filaire entre le transducteur 20 et les moyens d'acquisition 41 transporte un signal analogique.

Les fils ou câbles de connexion 3 peuvent cheminer entre les alvéoles dans des évidements prévus à cet effet ou déjà existants dans celles-ci. Par exemple pour une structure alvéolaire sandwich, les fils ou câbles de connexion 3 peuvent cheminer entre chaque alvéole et une des peaux composites, puis le long de ladite peau.

Ainsi, le cheminement et la protection du câblage peut être facilité du fait même de la structure alvéolaire.

Tout ou partie des moyens de traitement 40 des transducteurs (ou au moins d'un ou de quelques transducteurs) peut avantageusement être intégrée dans une alvéole afin de minimiser le câblage.

Les moyens d'acquisition 41 peuvent être disposés dans ou sur une alvéole, ou sur la surface d'une plaque, par exemple collés à ladite surface.

La transmission des transducteurs 20 vers tout ou partie des moyens de traitement 40 peut avantageusement être réalisée avec une communication sans fil 4.

Tout ou partie des moyens de traitement 40 peuvent être communs à plusieurs transducteurs si une fonction multiplexeur est ajoutée à des moyens de traitement 40.

Les moyens de calcul 42 ne sont en général pas embarqués. Dans ce domaine d'application de l'aéronautique, ils peuvent être amenés lorsque l'avion est au sol.

Les différents modes présentés peuvent être combinés entre eux.

En outre, la présente invention n'est pas limitée aux modes de réalisation précédemment décrits mais s'étend à tout mode de réalisation entrant dans la portée des revendications.

L'invention peut trouver des applications dans le domaine de l'aéronautique, par exemple dans une pièce d'un avion, telle que la pièce appelée IFS (Inner Fixed Structure) qui est une partie de la nacelle et qui peut comprendre une structure alvéolaire.

L'invention peut également trouver des applications dans d'autres domaines, par exemple dans les domaines du nautique, du spatial, du transport terrestre (ferroviaire, automobile), de l'énergie éolienne.

L'invention permet en effet de suivre l'évolution de l'état de santé de pièces, et ce, notamment afin de prévenir de potentielles ruptures.

## Revendications

1. Structure alvéolaire (1) comprenant plusieurs alvéoles (10), chaque alvéole étant délimitée par une paroi, ladite structure comprenant un dispositif de contrôle d'intégrité comprenant :
- au moins un transducteur piézoélectrique (20) apte à émettre une onde élastique (30a) de manière à ce que ladite onde émise se propage sur une distance donnée dans la structure (1), et positionné sur la paroi d'une alvéole (10) de ladite structure de manière à présenter au moins un point de contact avec ladite alvéole ;
- au moins un transducteur piézoélectrique (20) apte à recevoir, depuis l'onde élastique émise (30a), une onde élastique (30b) s'étant propagée sur une distance donnée dans la structure (1), et positionné sur la paroi d'une alvéole (10) de ladite structure de manière à présenter au moins un point de contact avec ladite alvéole ;
au moins une alvéole (10) comprenant plusieurs transducteurs piézoélectriques (20), formant ainsi un bloc (2) de transducteurs.

2. Structure alvéolaire (1) selon la revendication 1, au moins un transducteur piézoélectrique (20) apte à émettre une onde élastique et au moins un transducteur piézoélectrique (20) apte à recevoir une onde élastique étant un seul transducteur piézoélectrique (20) apte à émettre et à recevoir une onde élastique.

3. Structure alvéolaire (1) selon la revendication 1, comprenant au moins un premier transducteur piézoélectrique émetteur (20a) positionné sur une première alvéole (10a) et au moins un deuxième transducteur piézoélectrique récepteur (20b) positionné sur une seconde alvéole (10b).

4. Structure alvéolaire (1) selon la revendication 3, au moins deux transducteurs (20) étant en opposition de phase.

5. Structure alvéolaire (1) selon l'une des revendications 1 à 4, les parois délimitant les alvéoles (10) de ladite structure alvéolaire présentant chacune une section polygonale, de préférence hexagonale.

6. Structure alvéolaire (1) selon la revendication 5, un bloc (2) comprenant des transducteurs (20) répartis sur une ou plusieurs faces d'une alvéole (10), de préférence sur des faces adjacentes d'une alvéole (10).

7. Structure alvéolaire (1) selon la revendication 6, un bloc (2) comprenant des transducteurs (20) régulièrement répartis sur les faces d'une alvéole (10).

8. Structure alvéolaire (1) selon l'une des revendications 1 à 7, au moins une première alvéole (10a) comportant un bloc émetteur (2a) comprenant des transducteurs émetteurs (20a) et au moins une seconde alvéole (10b) comportant au moins un transducteur récepteur (20b).

9. Structure alvéolaire (1) selon l'une des revendications 1 à 8, au moins une première alvéole (10a) comportant un bloc émetteur (2a) comprenant des transducteurs émetteurs (20a) et au moins une seconde alvéole (10b) comportant un bloc récepteur (2b) comprenant des transducteurs récepteurs (20b).

10. Structure alvéolaire (1) selon l'une des revendications précédentes, le dispositif de contrôle d'intégrité comprenant en outre des moyens de traitement (40) du signal de l'onde élastique reçue, aptes à déterminer le niveau d'intégrité de ladite structure.

11. Structure alvéolaire (1) selon l'une des revendications précédentes, le dispositif de contrôle d'intégrité comprenant en outre des moyens de commande (50) du au moins un transducteur (20).

12. Structure alvéolaire (1) selon la revendication 11, les moyens de commande (50) comprenant des moyens de commutation aptes à basculer au moins un transducteur (20) du mode émission à un mode réception et inversement.

13. Structure alvéolaire (1) selon l'une des revendications précédentes, les moyens de traitement (40) comprenant des moyens de soustraction du signal de l'onde élastique reçue (30b) et d'un signal de référence correspondant à une structure alvéolaire saine.

14. Structure alvéolaire (1) selon l'une des revendications précédentes, le dispositif de contrôle d'intégrité comprenant également un capteur de température, les moyens de traitement (40) étant également configurés pour utiliser une mesure de température acquise par ledit capteur.

15. Procédé de contrôle d'intégrité d'une structure alvéolaire (1) comprenant les étapes suivantes :
- l'émission d'une onde élastique au moyen d'un transducteur piézoélectrique (20) de manière à ce que ladite onde émise se propage sur une distance donnée dans la structure alvéolaire (1) ;
- la réception par un transducteur piézoélectrique (20), depuis l'onde élastique émise, d'une onde élastique s'étant propagée sur une distance donnée dans la structure alvéolaire (1) ;
- le traitement du signal de l'onde élastique reçue de manière à déterminer le niveau d'intégrité de ladite structure alvéolaire ;
chaque transducteur piézoélectrique (20) étant positionné sur la paroi d'une alvéole (10) de la structure alvéolaire (1) de manière à présenter au moins un point de contact avec ladite alvéole ;
au moins une alvéole (10) comprenant plusieurs transducteurs piézoélectriques (20), formant ainsi un bloc (2) de transducteurs.

16. Pièce d'un avion comportant une structure alvéolaire selon l'une des revendications 1 à 14.

## Patentansprüche

1. Wabenstruktur (1), die mehrere Zellen (10) umfasst, wobei jede Zelle durch eine Wand begrenzt ist, wobei die Struktur eine Integritätsüberwachungsvorrichtung umfasst, die Folgendes umfasst:
- mindestens einen piezoelektrischen Wandler (20), der eine elastische Welle (30a) aussenden kann, so dass sich die ausgesendete Welle über eine gegebene Distanz in der Struktur (1) ausbreitet, und der an der Wand einer Zelle (10) der Struktur so positioniert ist, dass er mindestens einen Kontaktpunkt mit der Zelle aufweist;
- mindestens einen piezoelektrischen Wandler (20), der von der ausgesendeten elastischen Welle (30a) eine elastische Welle (30b) empfangen kann, die sich über eine gegebene Distanz in der Struktur (1) ausgebreitet hat, und der an der Wand einer Zelle (10) der Struktur so positioniert ist, dass er mindestens einen Kontaktpunkt mit der Zelle aufweist;
wobei mindestens eine Zelle (10) mehrere piezoelektrische Wandler (20) umfasst, so dass ein Block (2) von Wandlern gebildet wird.

2. Wabenstruktur (1) nach Anspruch 1, wobei mindestens ein piezoelektrischer Wandler (20), der eine elastische Welle aussenden kann, und mindestens ein piezoelektrischer Wandler (20), der eine elastische Welle empfangen kann, ein einziger piezoelektrischer Wandler (20) sind, der eine elastische Welle aussenden und empfangen kann.

3. Wabenstruktur (1) nach Anspruch 1, die mindestens einen auf einer ersten Zelle (10a) positionierten ersten piezoelektrischen Sendewandler (20a) und mindestens einen auf einer zweiten Zelle (10b) positionierten zweiten piezoelektrischen Empfangswandler (20b) umfasst.

4. Wabenstruktur (1) nach Anspruch 3, wobei mindestens zwei Wandler (20) gegenphasig sind.

5. Wabenstruktur (1) nach einem der Ansprüche 1 bis 4, wobei die die Zellen (10) der Wabenstruktur begrenzenden Wände jeweils einen polygonalen, vorzugsweise hexagonalen Querschnitt aufweisen.

6. Wabenstruktur (1) nach Anspruch 5, wobei ein Block (2) Wandler (20) umfasst, die auf einer oder mehreren Seiten einer Zelle (10), vorzugsweise auf benachbarten Seiten einer Zelle (10), verteilt sind.

7. Wabenstruktur (1) nach Anspruch 6, wobei ein Block (2) Wandler (20) umfasst, die gleichmäßig über die Seiten einer Zelle (10) verteilt sind.

8. Wabenstruktur (1) nach einem der Ansprüche 1 bis 7, wobei mindestens eine erste Zelle (10a) einen Sendeblock (2a) mit Sendewandlern (20a) umfasst und mindestens eine zweite Zelle (10b) mindestens einen Empfangswandler (20b) umfasst.

9. Wabenstruktur (1) nach einem der Ansprüche 1 bis 8, wobei mindestens eine erste Zelle (10a) einen Sendeblock (2a) mit Sendewandlern (20a) umfasst und mindestens eine zweite Zelle (10b) einen Empfangsblock (2b) mit Empfangswandlern (20b) umfasst.

10. Wabenstruktur (1) nach einem der vorherigen Ansprüche, wobei die Integritätsüberwachungsvorrichtung ferner Mittel zum Verarbeiten (40) des Signals der empfangenen elastischen Welle umfasst, die das Integritätsniveau der Struktur bestimmen können.

11. Wabenstruktur (1) nach einem der vorherigen Ansprüche, wobei die Integritätsüberwachungsvorrichtung ferner Mittel (50) zum Steuern des mindestens einen Wandlers (20) umfasst.

12. Wabenstruktur (1) nach Anspruch 11, wobei die Steuermittel (50) Schaltmittel umfassen, die mindestens einen Wandler (20) vom Sendemodus in einen Empfangsmodus und umgekehrt schalten können.

13. Wabenstruktur (1) nach einem der vorherigen Ansprüche, wobei die Verarbeitungsmittel (40) Mittel zum Subtrahieren des Signals von der empfangenen elastischen Welle (30b) und von einem Referenzsignal, das einer gesunden Wabenstruktur entspricht, umfassen.

14. Wabenstruktur (1) nach einem der vorherigen Ansprüche, wobei die Integritätsüberwachungsvorrichtung auch einen Temperatursensor umfasst, wobei die Verarbeitungsmittel (40) auch zum Nutzen eines von dem Sensor erfassten Temperaturmesswerts konfiguriert sind.

15. Verfahren zum Überwachen der Integrität einer Wabenstruktur (1), das die folgenden Schritte beinhaltet:
- Aussenden einer elastischen Welle mittels eines piezoelektrischen Wandlers (20), so dass sich die ausgesendete Welle über eine gegebene Distanz in der Wabenstruktur (1) ausbreitet;
- Empfangen, durch einen piezoelektrischen Wandler (20), einer elastischen Welle, die sich über eine gegebene Distanz in der Wabenstruktur (1) ausgebreitet hat, von der ausgesendeten elastischen Welle;
- Verarbeiten des Signals der empfangenen elastischen Welle, um das Integritätsniveau der Wabenstruktur zu bestimmen;
wobei jeder piezoelektrische Wandler (20) an der Wand einer Zelle (10) der Wabenstruktur (1) so positioniert ist, dass er mindestens einen Kontaktpunkt mit der Zelle aufweist;
wobei mindestens eine Zelle (10) mehrere piezoelektrische Wandler (20) umfasst, so dass ein Block (2) von Wandlern gebildet wird.

16. Flugzeugteil, das eine Wabenstruktur nach einem der Ansprüche 1 bis 14 umfasst.

## Claims

1. A honeycomb structure (1) comprising a plurality of cells (10), with each cell being defined by a wall, said structure comprising an integrity checking device comprising:
- at least one piezoelectric transducer (20) that is capable of emitting an elastic wave (30a) so that said emitted wave propagates over a given distance in the structure (1) and that is positioned on the wall of a cell (10) of said structure so as to have at least one point of contact with said cell;
- at least one piezoelectric transducer (20) that is capable of receiving, from the emitted elastic wave (30a), an elastic wave (30b) that has propagated over a given distance in the structure (1) and that is positioned on the wall of a cell (10) of said structure so as to have at least one point of contact with said cell;
with at least one cell (10) comprising a plurality of piezoelectric transducers (20), thus forming a block (2) of transducers.

2. The honeycomb structure (1) according to claim 1, wherein at least one piezoelectric transducer (20) capable of emitting an elastic wave and at least one piezoelectric transducer (20) capable of receiving an elastic wave is a single piezoelectric transducer (20) capable of emitting and receiving an elastic wave.

3. The honeycomb structure (1) according to claim 1, comprising at least one first emitter piezoelectric transducer (20a) positioned on a first cell (10a) and at least one second receiver piezoelectric transducer (20b) positioned on a second cell (10b).

4. The honeycomb structure (1) according to claim 3, wherein at least two transducers (20) are in phase opposition.

5. The honeycomb structure (1) according to any of claims 1 to 4, wherein the walls defining the cells (10) of said honeycomb structure each have a polygonal, preferably hexagonal, section.

6. The honeycomb structure (1) according to claim 5, a block (2) comprising transducers (20) distributed over one or more faces of a cell (10), preferably over adjacent faces of a cell (10).

7. The honeycomb structure (1) according to claim 6, a block (2) comprising transducers (20) evenly distributed over the faces of a cell (10).

8. The honeycomb structure (1) according to any of claims 1 to 7, at least one first cell (10a) comprising an emitter block (2a) comprising emitter transducers (20a) and at least one second cell (10b) comprising at least one receiver transducer (20b).

9. The honeycomb structure (1) according to any of claims 1 to 8, at least one first cell (10a) comprising an emitter block (2a) comprising emitter transducers (20a) and at least one second cell (10b) comprising a receiver block (2b) comprising receiver transducers (20b).

10. The honeycomb structure (1) according to any of the preceding claims, wherein the integrity checking device further comprises means (40) for processing the signal of the received elastic wave, said means being capable of determining the level of integrity of said structure.

11. The honeycomb structure (1) according to any of the preceding claims, wherein the integrity checking device further comprises means (50) for controlling the at least one transducer (20).

12. The honeycomb structure (1) according to claim 11, wherein the control means (50) comprise switching means capable of switching at least one transducer (20) from the emission mode to a reception mode and vice versa.

13. The honeycomb structure (1) according to any of the preceding claims, wherein the processing means (40) comprise means for subtracting the signal from the received elastic wave (30b) and from a reference signal corresponding to a sound honeycomb structure.

14. The honeycomb structure (1) according to any of the preceding claims, wherein the integrity-checking device also comprises a temperature sensor, with the processing means (40) also being configured to use a temperature measurement acquired by said sensor.

15. A method for checking the integrity of a honeycomb structure (1) comprising the following steps:
- emitting an elastic wave by means of a piezoelectric transducer (20) so that said emitted wave propagates over a given distance in the honeycomb structure (1);
- a piezoelectric transducer (20) receiving, from the emitted elastic wave, an elastic wave that has propagated over a given distance in the honeycomb structure (1);
- processing the signal of the received elastic wave so as to determine the level of integrity of said honeycomb structure;
with each piezoelectric transducer (20) being positioned on the wall of a cell (10) of the honeycomb structure (1) so as to have at least one point of contact with said cell;
with at least one cell (10) comprising multiple piezoelectric transducers (20), thus forming a block (2) of transducers.

16. A part of an aeroplane comprising a honeycomb structure according to any of claims 1 to 14.
